# EUROPEAN PATENT APPLICATION

(11) **EP 2 105 965 A2**
(43) Date of publication of application: **30.09.2009**
(21) Application number: 09290124.8
(22) Date of filing: 19.02.2009
(51) Int. Cl.: H01L 27/32

(54) **Organic light emitting display device**

(30) Priority: 19.02.2008 KR 20080014832
(71) Applicant: Samsung Mobile Display Co., Ltd., Suwon-si Gyeonggi-do (KR)
(72) Inventor: Kim, Hyang, Gyeonggi-Do (KR); Chae, Byung-Hoon, Gyeonggi-Do (KR); Kim, Kyung-Han, Gyeonggi-Do (KR)
(74) Representative: Bonnans, Arnaud

(57) **Abstract**

An organic light emitting display device capable of preventing the damage of wires (116) disposed in a boundary region (119) of a pad block (118) includes an organic light emitting display panel (100) including a pixel unit (112) and a pad block (118) electrically coupled to the pixel unit (112); coupling wires (116) extended from the pixel unit (112) to the pad block (118) to electrically couple the pad block (118) to the pixel unit (112); an insulating layer (130) disposed on one region of the coupling wires (116) disposed in a boundary region (119) of the pad block (118) and formed in a direction that crosses a direction in which the coupling wires (116) are extended; and an anisotropic conductive film (ACF) (140) formed on the insulating layer (130) to be overlapped with the one region of the coupling wires (116) in the boundary region (119) of the pad block (118) and to cover the entire surface of the pad block (118).

## Description

The present invention relates to an organic light emitting display device and a process, and more particularly, to an organic light emitting display device capable of preventing the damage of wires disposed in a boundary region of a pad block and a process fabricating the organic light emitting display device.

In recent years, there have been developed a variety of flat panel display devices that have less weight and volume than those of a cathode ray tube (CRT). In particular, an organic light emitting display device uses an organic compound as a light emitting material and has drawn attention due to the excellent luminance and color purity.

Generally, the organic light emitting display device includes a pixel unit including a plurality of pixels disposed at intersection points of scan lines and data lines, and driving circuits for driving the pixel unit.

Each of the pixels includes an organic light emitting diode including an anode electrode, a cathode electrode, and an organic light emitting layer formed between the anode electrode and the cathode electrode.

The pixel unit of the organic light emitting display device is however generally sealed by an encapsulation member since the organic light emitting layer is easily degraded by moisture and oxygen. Therefore, a display panel of the organic light emitting display device where the pixel unit is formed, is composed of a substrate for forming pixels and an encapsulation member attached to the substrate with a seal member sealing a pixel region.

The driving circuits generate driving signals for driving the pixel unit corresponding to power sources and control signals supplied from the exterior, and supply the generated driving signals to the pixel unit. For example, the driving circuits may generate a scan signal for selecting pixels and a data signal for determining light emission luminance of the pixels, and supply the generated scan signal and data signal to the pixels.

For this purpose, connection wires, e.g., scan lines and/or data lines, for transferring signals are formed between the driving circuits and the pixel unit.

The driving circuits, however, are generally disposed outside the seal region by means of the encapsulation member. For example, the driving circuits may be mounted on a flexible printed circuit board (FPCB) electrically coupled to the display panel through the pad block, etc. Also, the driving circuits may be mounted in the form of an integrated circuit (IC) chip on a non-seal region of the display panel.

Therefore, the signal lines such as scan lines and/or data lines are formed to be extracted from the inner part of the seal region to the non-seal region. In particular, the signal lines are electrically coupled to the FPCB through the pad block when the drive circuits are mounted on the FPCB.

Also, the power lines for supplying first and second pixel power sources (ELVDD and ELVSS) to the pixel unit are also electrically coupled with a power supply unit through the pad block, the pad block being formed in the exterior of the display panel.

For this purpose, sides of the signal lines and/or power lines extracted from the seal region where the pixel unit is formed, are extended to a region of the pad block to form pad electrodes. Also, conductive films such as an anisotropic conductive film (ACF) are formed on the pad electrodes. The pad block of the FPCB is arranged on the ACF. Then, the pad electrodes of the display panels are electrically coupled to the pad block of the FPCB using a pressing process, thereby electrically coupling the display panel to the FPCB.

In the event that the ACF should burst during the pressing process, however, some of the ACF may leak out and damage the connection wires disposed in a boundary region of the pad block. Therefore, the connection wires may become corroded and thus cause a short circuit between adjacent connection wires or even cause a disconnection (i.e., an electrically open circuit) between some of connection wires.

It is therefore an object of the present invention to provide an improved an organic light emitting display device and a process fabricating the organic light emitting display device in order to overcome the above stated drawbacks of the prior art.

It is another objection of the present invention to provide an organic light emitting display device capable of preventing the damage of wires disposed in a boundary region of a pad block and a process fabricating the organic light emitting display device.

One embodiment of the present invention provides an organic light emitting display device including an organic light emitting display panel including a pixel unit and a pad block electrically coupled to the pixel unit; coupling wires extended from the pixel unit to the pad block in order to electrically couple the pad block to the pixel unit; an insulating layer disposed on one region of the coupling wires disposed in a boundary region of the pad block and formed in a direction that crosses a direction where the coupling wires are extended; and an anisotropic conductive film (ACF) formed on the insulating layer to be overlapped with the one region of the coupling wires in the boundary region of the pad block and to cover the entire surface of the pad block.

Here, the insulating layer may be formed with a width of at least 150 µm in a direction extending toward the pixel unit from the end of the anisotropic conductive film disposed in the boundary region of the pad block. Also, the insulating layer may be formed with a width of at least 150 µm in a direction, which is opposite to the pixel unit, toward one side edge of the organic light emitting display panel from the end of the anisotropic conductive film disposed in the boundary region of the pad block. In addition, the insulating layer may be formed within a region at least ±150 µm on the end of the anisotropic conductive film disposed in the boundary region of the pad block.

Also, the pad block may include a plurality of pad electrodes extending from the coupling wires.

In addition, the insulating layer may be formed of an inorganic insulating layer.

Additionally, the boundary region of the pad block that is overlapped with the insulating layer may be set to one of edge regions of the pad block disposed between the pad block and the pixel unit.

Furthermore, the organic light emitting display device constructed as the present invention may further include a flexible printed circuit board (FPCB) electrically coupled to the organic light emitting display panel by means of the anisotropic conductive film.

A more complete appreciation of the invention, and many of the attendant advantages thereof, will be readily apparent as the same becomes better understood by reference to the following detailed description when considered in conjunction with the accompanying drawings in which like reference symbols indicated the same or similar components, wherein:
- FIG. 1 is an oblique view showing a display panel of an organic light emitting display device constructed as one exemplary embodiment of the present invention;
- FIG. 2 is a cross-sectional view of the display panel taken along line I-I' in FIG. 1; and
- FIGS. 3A through 3C are oblique views showing procedures of coupling an FPCB to the display panel as shown in FIG. 1.

In the following detailed description, only certain exemplary embodiments of the present invention have been shown and described, simply by way of illustration. As those skilled in the art would realize, the described embodiments may be modified in various different ways. Accordingly, the drawings and description are to be regarded as illustrative in nature and not restrictive. In addition, when an element is referred to as being "on" another element, it can be directly on the element or be indirectly on the element with one or more intervening elements interposed therebetween. Also, when an element is referred to as being "connected to" another element, it can be directly connected to the element or be indirectly connected to the element with one or more intervening elements interposed therebetween. Hereinafter, like reference numerals refer to like elements.

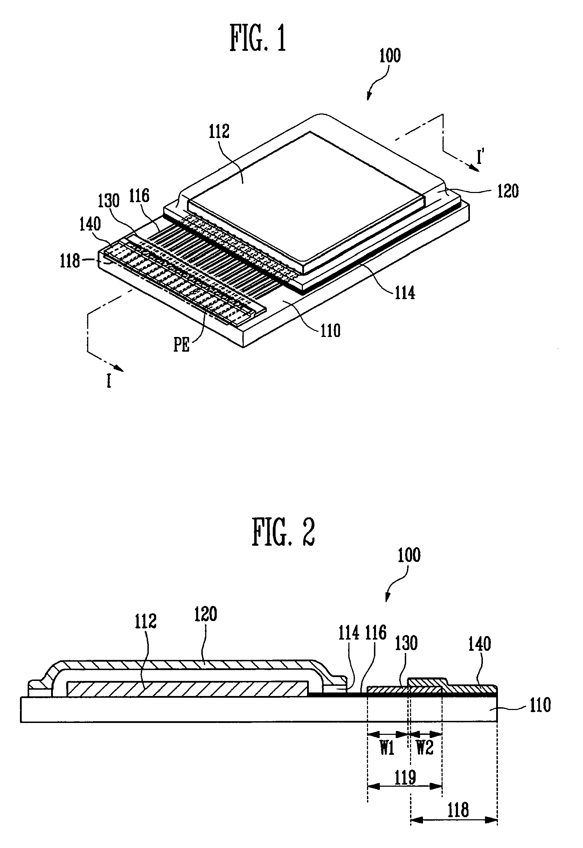

FIG. 1 is a perspective view showing a display panel of an organic light emitting display device according to one exemplary embodiment of the present invention. FIG. 2 is a cross-sectional view of the display panel taken along line I-I' in FIG. 1.

Referring to FIGS. 1 and 2, display panel 100 of the organic light emitting display device includes a pixel unit 112 and a pad block 118.

Pixel unit 112 includes a plurality of pixels (not shown), each of which includes at least one organic light emitting diode. Pixel unit 112 is sealed by an encapsulation member 120 that is firmly attached to a substrate 110 by means of a seal member 114. Here, encapsulation member 120 may be formed of a glass substrate or a metal cap, etc.

Pad block 118 includes a plurality of pad electrodes (PE) for transferring power sources and/or drive signals supplied from the external environments. Pad block 118 is electrically coupled to pixel unit 112 by means of coupling wires 116.

Coupling wires 116 are extended from pixel unit 112 to pad block 118 to electrically couple pad block 118 to pixel unit 112. Such coupling wires 116 may be set to power lines and/or signal lines for transferring the power sources and/or driving signals and supplying the power sources and/or driving signals to pad block 118, and then to pixel unit 112.

For example, coupling wires 116 may include power lines for transferring first and second pixel power sources (ELVDD and ELVSS), scan lines for transferring a scan signal, and/or data lines for transferring a data signal.

One terminal of such coupling wire 116 may be extended to pad block 118 to form pad electrodes (PE). Also, coupling wires 116 are formed separately from the pad electrodes (PE) and may be electrically coupled to the pad electrodes (PE) through contact holes and the like (not shown). Hereinafter, it is described on the assumption that one terminal of coupling wire 116 may be extended to form pad electrodes (PE) for the sake of convenience.

In the present invention, however, at least one insulating layer 130 is formed on one region of coupling wires 116 disposed in boundary region 119 of pad block 118, insulating layer 130 being formed in a direction where coupling wires 116 are crossed over. Here, boundary region 119 of pad block 118 where insulating layer 130 is formed, refers to an edge region of pad block 118, among the edge regions of pad block 118, that is disposed between pad block 118 and pixel unit 112.

Insulating layer 130 is formed to prevent coupling wires 116 from being damaged by an anisotropic conductive film (ACF) for electrically coupling pad block 118 to a connector such as FPCB (not shown).

More particularly, if there is no insulating layer 130 present, ACF 140 may burst during a pressing process of ACF 140 in order to electrically couple FPCB to pad block 118 of display panel 100 so that some of ACF 140 may leak out. Leaked ACF 140 may damage coupling wires 116 disposed in boundary region 119 of pad block 118.

One region of coupling wires 116 constituting the pad electrodes (PE) is normally electrically coupled to the FPCB by means of ACF 140. When ACF 140 permeates into a region disposed in boundary region 119 of pad block 118 among the other regions of coupling wires 116 disposed in the exterior of pad block 118, however, coupling wires 116 may be damaged.

Therefore, insulating layer 130 is formed between coupling wires 116 and ACF 140, both of which are disposed in the boundary region of pad block 118, so as to prevent the damage of coupling wires 116 in the present invention.

Insulating layer 130 is preferably formed with an inorganic insulating layer to effectively prevent foreign substances such as moisture from penetrating into coupling wires 116. Also, insulating layer 130 may be formed of the same material as one of the inorganic insulating layers formed inside pixel unit 112 at the same time of forming pixel unit 112 for convenience sake of the process. For example, insulating layer 130 may be formed as a gate insulating layer and/or an interlayer insulating layer of pixel unit 112.

In order to effectively protect coupling wires 116, insulating layer 130 is, however, preferably formed with a width of at least 150 µm in a direction toward pixel unit 112 from the end of ACF 140 that is disposed in the boundary region of pad block 118. That is, the width (hereinafter, referred to as 'W1') of insulating layer 130 in the direction toward pixel unit 112 from the end of ACF 140 may be set to a minimum width of 150 µm. Here, width W1 may have a maximum value widely varied according to the size and/or configuration of display panel 100, which is not limited to a specific value.

Also, insulating layer 130 is preferably formed with a width of at least 150 µm in an opposite direction to pixel unit 112 from the end of ACF 140 disposed in the boundary region of pad block 118, i.e., in a direction toward one side edge of display panel 100 in which pad block 118 is formed. That is, the width (hereinafter, referred to as 'W2') of insulating layer 130 in the opposite direction to pixel unit 112 from the end of ACF 140 may be set to a minimum width of 150 µm. Here, width W2 may also have a maximum value widely varied according to the size and/or configuration of display panel 100. The maximum value of width W2 however should be set within a range where a contact resistance between the pad electrodes (PE) and the FPCB, which are electrically coupled to each other by means of ACF 140, do not hinder the supply of the power sources and/or the drive signals.

That is to say, insulating layer 130 is formed within a region at least ±150 µm on the end of ACF 140 disposed in the boundary region of pad block 118. Also, insulating layer 130 may be formed beyond the region according to the size and/or configuration of display panel 100. At this time, the width of insulating layer 130 is the sum of W1 and W2, and therefore insulating layer 130 has a minimum width of 300 µm.

In the present invention, ACF 140 is formed to cover the entire surface of pad block 118, and disposed in the end of pad block 118. That is, ACF 140 is formed on insulating layer 130 to be overlapped with one region of insulating layer 130 in boundary region 119 of pad block 118.

The connector (not shown) such as FPCB, TAB IC, and the like is disposed on ACF 140, and ACF 140 conducts the connector such as FPCB, TAB IC and the like with pad block 118 of display panel 100 after the pressing process for forming ACF 140.

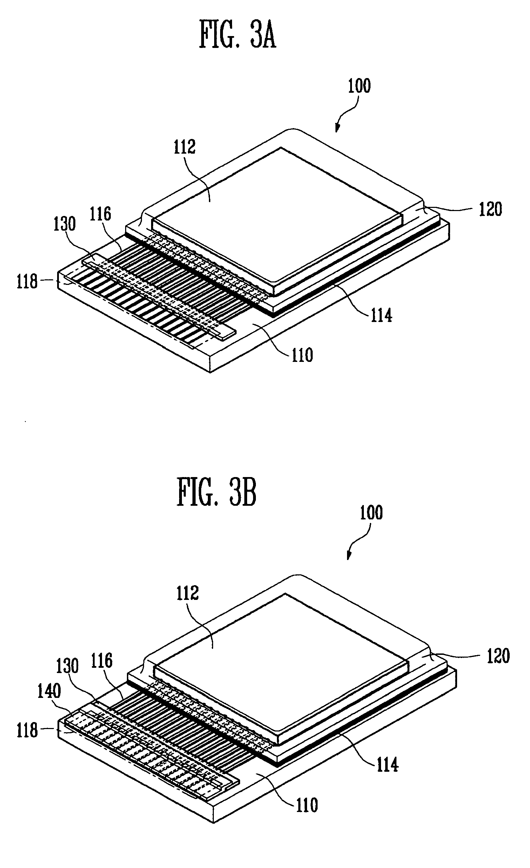

Hereinafter, a process of coupling the FPCB to the display panel as shown in FIGS. 1 and 2 will be described in more detail with reference to FIGS. 3A to FIG. 3C.

Referring to FIG. 3A to FIG. 3C, display panel 100 in which insulating layer 130 is formed on coupling wires 116 is first prepared, as shown in FIG. 3A. And, ACF 140 is formed to cover the entire surface of pad block 118, as shown in FIG. 3B. At this time, ACF 140 is formed on insulating layer 130 so that insulating layer 130 and one region of ACF 140 may be overlapped with each other.

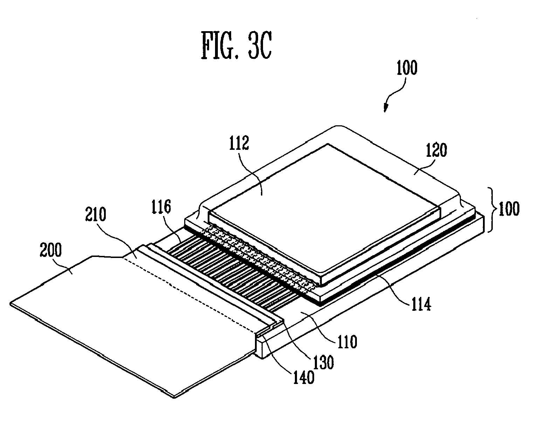

Then, pad block 210 of FPCB 200 is arranged on ACF 140 as shown in FIG. 3C, and a pressing process is carried out by giving a pressure onto ACF 140. Therefore, FPCB 200 is electrically coupled to display panel 100 through ACF 140.

FPCB 200 is coupled to an external drive board (not shown) to supply power sources and/or drive signals to display panel 100, the power sources and/or drive signals being transferred from the external drive board. Also, FPCB 200 generates a drive signal to correspond to the externally supplied power sources and/or control signals since drive ICs such as a scan driver and/or a data driver are mounted in FPCB 200, and then supplies the generated drive signal to display panel 100.

According to the exemplary embodiments of the present invention that have been described with reference to FIGS. 1 to 3c, it is possible to prevent coupling wires 116 from being damaged by ACF 140 during the pressing process of ACF 140 by forming insulating layer 130 on one region of coupling wires 116 disposed in the boundary region of pad block 118. Also, it is possible to protect coupling wires 116 from moisture and the like that are permeable during a module operation.

Therefore, the damage of coupling wires 116 may be prevented and thus a possibility of a short circuit and/or a disconnection between wires may be eliminated, thereby improving the reliability of the organic light emitting display device.

Meanwhile, insulating layer 130 is formed only in one region of coupling wires 116 disposed in the boundary region of pad block 118, as shown in FIGS. 1 to 3C, the present invention is however not particularly limited thereto. For example, a separate dielectric passivation layer may be further formed on one region of coupling wires 116 that are formed in the remaining regions except for pad block 118. Insulating layer 130 may be made of electrical and thermal insulated material.

Also, the above-mentioned exemplary embodiments show that the scan driver and/or the data driver are, for example, mounted in FPCB 200 disposed in the exterior of display panel 100, the present invention however is not particularly limited thereto.

For example, the scan driver and/or the data driver may be formed on display panel 100 at the same time as the pixel circuits, or mounted on display panel 100 in the form of IC chips.

In this case, it is considered that coupling wires 116 include wires for coupling pad block 118 to the scan driver and/or data driver.

While the present invention has been described in connection with certain exemplary embodiments, it is to be understood that the invention is not limited to the disclosed embodiments.

## Claims

1. An organic light emitting display device, comprising:
an organic light emitting display panel (100) including a pixel unit (112) and a pad block (118) electrically coupled to the pixel unit (112);
coupling wires (116) extended from the pixel unit (112) to the pad block (118) in order to electrically couple the pad block (118) to the pixel unit (112);
an insulating layer (130) disposed on one region of the coupling wires (116) disposed in a boundary region (119) of the pad block (118) and formed in a first direction that crosses a second direction along which the coupling wires (116) are extended; and
an anisotropic conductive film (140) formed on the insulating layer (130) to be overlapped with the one region of the coupling wires (116) in the boundary region (119) of the pad block (118) and to cover an entire surface of the pad block (118).

2. The organic light emitting display device according to claim 1, wherein the insulating layer (130) is formed with a width of at least 150 µm in a direction toward the pixel unit (112) from one end of the anisotropic conductive film (140) disposed in the boundary region (119) of the pad block (118).

3. The organic light emitting display device according to claim 1 or 2, wherein the insulating layer (130) is formed with a width of at least 150 µm in a direction, which is opposite to the pixel unit (112), toward one side edge of the organic light emitting display panel (100) from the one end of the anisotropic conductive film (140) disposed in the boundary region (119) of the pad block (118), with the one side edge of the organic light emitting display panel (100) being where the anisotropic conductive film (140) is disposed.

4. The organic light emitting display device according to claim 1, wherein the insulating layer (130) is formed within a region where at least 150 µm is on a first side of the one end of the anisotropic conductive film (140) disposed in the boundary region (119) of the pad block (118) and at least 150 µm is on a second side of the one end of the anisotropic conductive film (140) disposed in the boundary region (119) of the pad block (118) with the second side being opposite to the first side.

5. The organic light emitting display device according to any of claims 1 to 4, wherein the pad block (118) includes a plurality of pad electrodes (PE) extended from the coupling wires (116).

6. The organic light emitting display device according to any of claims 1 to 5, wherein the insulating layer (130) is an inorganic insulating layer.

7. The organic light emitting display device according to any of claims 1 to 6, wherein the boundary region (119) of the pad block (118) that is overlapped with the insulating layer (130) is set to one of edge regions of the pad block (118) disposed between the pad block (118) and the pixel unit (112).

8. The organic light emitting display device according to any of claims 1 to 7, further comprising a flexible printed circuit board (200) electrically coupled to the organic light emitting display panel (100) by means of the anisotropic conductive film (140).

9. A method of fabricating an organic light emitting display device, the method comprising:
forming an organic light emitting display panel (100) comprising a pixel unit (112) and a pad block (118) electrically coupled to the pixel unit (112);
electrically coupling the pad block (118) to the pixel unit (112) by a plurality of coupling wires (116) extended from the pixel unit (112) to the pad block (118);
forming an insulating layer (130) on one region of the plurality of coupling wires (116) disposed in a boundary region (119) of the pad block (118) and formed in a first direction that crosses a second direction along which the coupling wires (116) are extended; and
forming an anisotropic conductive film (140) on the insulating layer (130), with the anisotropic conductive film (140) being overlapped with the one region of the coupling wires (116) in the boundary region (119) of the pad block (118) and covering an entire surface of the pad block (118).

10. The method of claim 9, comprising:
electrically coupling a flexible printed circuit board (200) to the organic light emitting display panel (100) by the anisotropic conductive film (140).
